(19) Europäisches Patentamt
European Patent Office
Office européen des brevets

(11) **EP 3 195 000 B1**

(12) **EUROPÄISCHE PATENTSCHRIFT**

(45) Veröffentlichungstag und Bekanntmachung des Hinweises auf die Patenterteilung:
**19.02.2020   Patentblatt 2020/08**

(21) Anmeldenummer: **15766463.2**

(22) Anmeldetag: **17.09.2015**

(51) Int Cl.:
*G01R 27/16* (2006.01)   *G06F 1/00* (2006.01)
*G09G 1/00* (2006.01)   *G01R 1/20* (2006.01)
*G01R 19/00* (2006.01)   *G01R 35/00* (2006.01)
*G11C 5/00* (2006.01)

(86) Internationale Anmeldenummer:
**PCT/EP2015/071355**

(87) Internationale Veröffentlichungsnummer:
**WO 2016/042091 (24.03.2016 Gazette 2016/12)**

(54) **KALIBRIERUNG VON STROMSENSOREN MITTELS REFERENZSTROM WÄHREND DER STROMMESSUNG**

CALIBRATION OF CURRENT SENSORS BY MEANS OF A REFERENCE CURRENT DURING THE CURRENT MEASUREMENT

ÉTALONNAGE DE CAPTEURS DE COURANT AU MOYEN DU COURANT DE RÉFÉRENCE PENDANT LA MESURE DU COURANT

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **17.09.2014   DE 102014218710**
**30.04.2015   DE 102015208135**

(43) Veröffentlichungstag der Anmeldung:
**26.07.2017   Patentblatt 2017/30**

(73) Patentinhaber:
• **Continental Teves AG & Co. OHG**
**60488 Frankfurt am Main (DE)**
• **Continental Automotive GmbH**
**30165 Hannover (DE)**

(72) Erfinder:
• **SCHRAMME, Martin**
**86343 Königsbrunn (DE)**
• **JÖCKEL, Wolfgang**
**36129 Gersfeld (DE)**

(56) Entgegenhaltungen:
**EP-A1- 2 128 633**   **DE-A1- 19 801 361**
**DE-A1-102010 028 066**   **DE-A1-102012 006 269**
**DE-A1-102012 014 969**   **DE-B3- 10 229 895**
**DE-C1- 19 507 959**   **US-A1- 2013 154 672**

## Beschreibung

Die Erfindung betrifft ein Verfahren zum Messen eines Stromes mit einem Stromsensor.

Elektrische Ströme in und aus einer Fahrzeugbatterie werden beispielsweise in der DE 10 2009 044 992 A1, in der DE 10 2004 062 655 A1 und in der DE 10 2010 028066 A1 mit einem Stromsensor über einen Messwiderstand, auch Shunt genannt, gemessen.

Es ist Aufgabe der vorliegenden Erfindung das bekannte Verfahren zur Strommessung zu verbessern.

Die Aufgabe wird durch die Merkmale der unabhängigen Ansprüche gelöst. Bevorzugte Weiterbildungen sind Gegenstand der abhängigen Ansprüche.

Gemäß einem Aspekt der Erfindung umfasst ein Verfahren zum Kalibrieren eines Stromsensors, der eingerichtet ist, in einem Bordnetz eines Fahrzeuges einen durch einen Messwiderstand fließenden elektrischen Betriebsstrom basierend auf einer Gegenüberstellung eines durch den Betriebsstrom hervorgerufenen Spannungsabfalls am Messwiderstand und einer vom Messwiderstand abhängigen Vorschrift zu bestimmen, die Schritte Bestimmen eines durch den Betriebsstrom am Messwiderstand hervorgerufenen Betriebsspannungsabfalls, Einprägen eines bekannten elektrischen Kalibrierstromes in den Messwiderstand, Erfassen eines durch den Kalibrierstrom und den Betriebsstrom am Messwiderstand hervorgerufenen Gesamtspannungsabfalls, Filtern des Betriebsspannungsabfalls aus dem Gesamtspannungsabfall, so dass ein durch den Kalibrierstrom hervorgerufener Kalibrierspannungsabfall verbleibt, und Kalibrieren der vom Messwiderstand abhängigen Vorschrift basierend auf einer Gegenüberstellung des Kalibrierstromes und des Kalibrierspannungsabfalls.

Dem angegebenen Verfahren liegt die Überlegung zugrunde, dass der auch Shunt genannte Messwiderstand mit Toleranzen behaftet ist. Der Messwiderstand sollte daher hinsichtlich dieser Toleranzen stabil ausgelegt werden, was entsprechend teuer ist. Alternativ könnte auch ein kostengünstigerer Messwiderstand verwendet werden, wenn sich die entsprechenden Toleranzen erfassen und korrigieren lassen. Hierzu könnte der Messwiderstand mit einem bekannten Kalibrierstrom vermessen und kalibriert werden.

Der Messwiderstand sollte bei der Kalibrierung nicht mit dem unbekannten Betriebsstrom beaufschlagt werden. Das ist insofern problematisch, weil sich so nur langzeitdynamische Toleranzen berücksichtigen lassen, wie sie beispielsweise durch die Alterung des Messwiderstandes entstehen. Kurzzeitdynamische Toleranzen, beispielsweise durch Temperaturabhängigkeiten des Messwiderstandes bedingt, lassen sich so nicht berücksichtigen, weil diese sich im Betrieb des Messwiderstandes unter dem angelegten Betriebsstrom oder der Umgebungstemperatur erst entwickeln. Aus diesem Grund ist für den Messwiderstand zumindest hinsichtlich seiner Kurzzeitdynamik ein entsprechend teures Material zu wählen.

Hier greift das angegebene Verfahren mit dem Vorschlag an, während der Kalibrierung zunächst den Betriebsspannungsabfall am fehlerbehafteten Messwiderstand zu bestimmen, der folglich ebenfalls fehlerbehaftet ist. Anschließend wird der unter dem Betriebsstrom stehende fehlerbehaftete Messwiderstand zusätzlich mit dem Kalibrierstrom beaufschlagt und der resultierende Gesamtspannungsabfall abgegriffen. Schließlich wird der Gesamtspannungsabfall vom fehlerbehafteten Betriebsspannungsabfall bereinigt. Durch diese Bereinigung wird auch der Fehler aus dem Gesamtspannungsabfall entfernt, so dass danach der tatsächliche Kalibrierspannungsabfall zur Verfügung steht, mit dem sich auch während des Betriebes der Stromsensor kalibrieren lässt, um kurzzeitdynamische Toleranzen zu unterdrücken oder auszulöschen.

Daher können bei der Wahl des Messwiderstandes auch kurzzeitdynamische Toleranzen unberücksichtigt bleiben und ein entsprechend kostengünstiges Material für diesen gewählt werden.

Zweckmäßigerweise umfasst der Kalibrierstrom einen periodischen Strompuls.

In einer Weiterbildung des angegebenen Verfahrens ist der Kalibrierstrom ein Strompuls mit einer Pulsbreite, insbesondere von weniger als 10ps. Dieser Weiterbildung liegt die Überlegung zugrunde, dass der Kalibrierstrom möglichst konstant mit wenigen kurzzeitdynamischen Veränderungen erfasst werden sollte, wie sie beispielsweise durch elektrisch bedingte Temperaturveränderungen hervorgerufen werden. Je kürzer der Strompuls daher gewählt wird, desto sicherer lassen sich die kurzzeitdynamischen Veränderungen ausblenden.

In einer zweckmäßigen Weiterbildung des angegebenen Verfahrens wird zum Bestimmen des Betriebsspannungsabfalls eine charakteristische Größe des Betriebsspannungsabfalls aus wenigstens zwei Betriebsspannungsmesswerten bestimmt, die außerhalb des Strompulses erfasst werden. Unter der charakteristischen Größe soll nachstehend ein Wert verstanden werden, der den Verlauf eines Wechselsignals hinsichtlich einer bestimmten physikalischen Eigenschaft charakterisiert. Derartige charakteristische Größen sind beispielsweise Mittelwerte, Effektivwerte, Gleichrichtwerte, und so weiter. Der Weiterbildung liegt die Überlegung zugrunde, dass der Betriebsspannungsabfall und der Gesamtspannungsabfall eigentlich zeitlich gemeinsam gemessen werden sollten, damit der oben genannte Fehler im Betriebsspannungsabfall möglichst vollständig aus dem Gesamtspannungsabfall bereinigt werden kann. Andererseits können der Betriebsspannungsabfall und der Gesamtspannungsabfall prinzipbedingt nur nacheinander gemessen werden. Um diesen Widerspruch aufzulösen, wird im Rahmen der vorliegenden Weiterbildung vorgeschlagen, den Betriebsspannungsabfall während des angelegten Strompulses zu schätzen und aus dem geschätzten Betriebsspannungsabfall einen geeigneten Messwert für den Betriebsspannungsabfall zu schätzen. Dieser geeignete Messwert wird durch die charakteristische Größe beschrieben.

Das Schätzen kann dabei mit beliebigen Mitteln, beispielsweise durch Interpolation oder Extrapolation erfolgen. In technisch besonders einfacher Weise lässt sich das zuvor genannte Schätzen und Bestimmten der charakteristischen Größe realisieren, wenn als charakteristische Größe der Mittelwert zwischen den beiden erfassten Betriebsspannungsmesswerten erfasst wird.

In einer besonders bevorzugten Weiterbildung des angegebenen Verfahrens liegt der Strompuls zwischen den Betriebsspannungsmesswerten. Auf diese Weise wird ein besonders kleiner Schätzfehler beim Schätzen des Betriebsspannungsabfalls insbesondere bei der Mittelwertbildung erreicht.

In einer anderen Weiterbildung des angegebenen Verfahrens werden der Gesamtspannungsabfall und die Betriebsspannungsmesswerte mit wenigstens einem Analog-Digitalwandler in je einen Digitalwert umgewandelt und in je einem eigenen Speicher hinterlegt. Die in den Speichern hinterlegten Werte liegen dann alle synchron vor, so dass der Kalibrierspannungsabfall, der zur Kalibrierung des Stromsensors notwendig ist, mit einem einfachen Rechenwerk bestimmbar ist.

In einer bevorzugten Weiterbildung des angegebenen Verfahrens werden der Gesamtspannungsabfall und die Betriebsspannungsmesswerte mit je einem eigenen Analog-Digitalwandler umgewandelt, wobei die Analog-Digitalwandler in zeitlichen Abständen untereinander vertauscht werden. Durch das Vertauschen der einzelnen Analog-Digitalwandler untereinander wird ein Interleaving erreicht, wodurch die Fehlerabhängigkeiten auf alle in den Kalibrierspannungsabfall eingehenden Messwerte gleichmäßig verteilt werden.

In einer anderen bevorzugten Weiterbildung des angegebenen Verfahrens werden der Gesamtspannungsabfall und die Betriebsspannungsmesswerte zwischengespeichert und zeitlich versetzt über einen gemeinsamen Analog-Digitalwandler in je einen Digitalwert umgewandelt. Auf diese Weise kann nicht nur ein in kostengünstiger Weise einzelner Analog-Digitalwandler bei der Bestimmung des Kalibrierspannungsabfalls verwendet werden, Die Verwendung eines einheitlichen Analog-Digitalwandlers bringt auch eine einheitliche Fehlerabhängigkeit in die in den Kalibrierspannungsabfall eingehenden Messwerte ein, die dann rechentechnisch wieder herausgekürzt werden können.

Das Verfahren ist bevorzugt dadurch weitergebildet, dass der durch den Kalibrierstrom und den Betriebsstrom am Messwiderstand hervorgerufenen Gesamtspannungsabfall mittels wenigstens einer Verstärkerstufe verstärkt wird, insbesondere bevor das Filtern des Betriebsspannungsabfalls aus dem Gesamtspannungsabfall durchgeführt wird.

Es ist bevorzugt, dass der Verstärkerstufe zumindest eine Chopperschaltung vorgeschaltet ist, welche das Signal des Gesamtspannungsabfalls in ein Wechselsignal wandelt, wobei insbesondere die Polarität des Signals des Gesamtspannungsabfalls periodisch vertauscht wird. Besonders bevorzugt ist dabei der Betrieb und/oder die Taktung der Chopperschaltung so ausgelegt, dass innerhalb eines Zeitintervalls, begrenzt durch die Zeitpunkte zu denen die zwei Betriebsspannungsmesswerte bestimmt werden, die außerhalb des Strompulses erfasst werden, kein Polaritätswechsel und/oder Periodenwechsel der Chopperschaltung durchgeführt wird.

Es ist zweckmäßig, dass beim Bestimmen des Betriebsspannungsabfalls aus dem Gesamtspannungsabfall, ein De-Chopperglied verwendet wird, und insbesondere beim Bestimmen des Kalibrierspannungsabfalls kein De-Chopperglied verwendet wird.

Gemäß einem weiteren Aspekt der Erfindung ist eine Steuervorrichtung eingerichtet, ein Verfahren nach einem der vorstehenden Ansprüche durchzuführen.

In einer Weiterbildung der angegebenen Steuervorrichtung weist die angegebene Vorrichtung einen Speicher und einen Prozessor auf. Dabei ist das angegebene Verfahren in Form eines Computerprogramms in dem Speicher hinterlegt und der Prozessor zur Ausführung des Verfahrens vorgesehen, wenn das Computerprogramm aus dem Speicher in den Prozessor geladen ist.

Gemäß einem weiteren Aspekt der Erfindung umfasst ein Computerprogramm Programmcodemittel, um alle Schritte eines der angegebenen Verfahren durchzuführen, wenn das Computerprogramm auf einem Computer oder einer der angegebenen Vorrichtungen ausgeführt wird.

Gemäß einem weiteren Aspekt der Erfindung enthält ein Computerprogrammprodukt einen Programmcode, der auf einem computerlesbaren Datenträger gespeichert ist und der, wenn er auf einer Datenverarbeitungseinrichtung ausgeführt wird, eines der angegebenen Verfahren durchführt.

Gemäß einem anderen Aspekt der Erfindung umfasst ein Stromsensor zum Messen eines elektrischen Stromes einen elektrischen Messwiderstand, über den der zu messende elektrische Strom führbar ist eine der angegebenen Steuervorrichtungen.

Gemäß einem anderen Aspekt der Erfindung umfasst ein Fahrzeug eine der angegebenen Steuervorrichtungen und/oder den angegebenen Stromsensor.

Die oben beschriebenen Eigenschaften, Merkmale und Vorteile dieser Erfindung sowie die Art und Weise, wie diese erreicht werden, werden klarer und deutlicher verständlich im Zusammenhang mit der folgenden Beschreibung der Ausführungsbeispiele, die im Zusammenhang mit den Zeichnungen näher erläutert werden, wobei:

Fig. 1 eine Prinzipdarstellung eines an ein Bordnetz eines Fahrzeuges angeschlossenen Stromsensor,

Fig. 2 die Prinzipdarstellung der Fig. 1 mit einer alternativen Linienwahl,

Fig. 3 ein zeitliches Diagramm mit im Stromsensor der Fig. 1 abfallenden Spannungen,

Fig. 4 eine zeitliches Diagramm mit Steuersignalen für den Stromsensor aus Fig. 1,

Fig. 5 eine Prinzipdarstellung eines alternativen an ein Bordnetz eines Fahrzeuges angeschlossenen Stromsensor, und

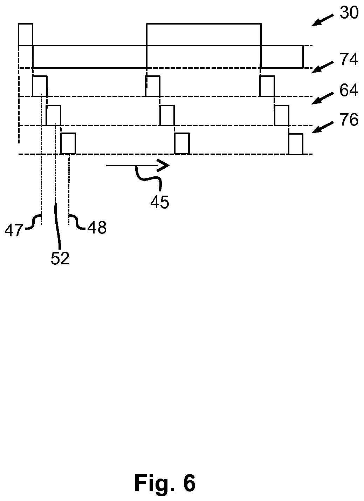

Fig. 6 eine zeitliches Diagramm mit Steuersignalen für den Stromsensor aus Fig. 3 zeigen.

In den Figuren werden gleiche technische Elemente mit gleichen Bezugszeichen versehen und nur einmal beschrieben.

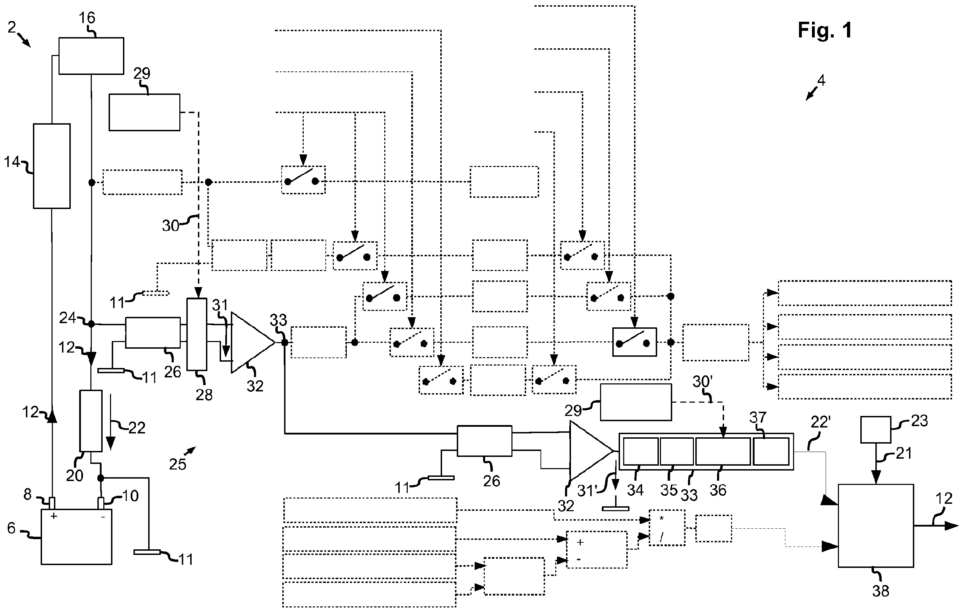

Es wird auf Fig. 1 Bezug genommen, die eine Prinzipdarstellung eines an ein Bordnetz 2 eines nicht weiter dargestellten Fahrzeuges angeschlossenen Stromsensors 4 zeigt. Die fein gestrichelt dargestellten Linien sollen in Fig. 1 zunächst unberücksichtigt bleiben, um das Funktionsprinzip des Stromsensors 4 näher zu erläutern. Die fein gestrichelt dargestellten Elemente in Fig. 1 sind daher auch nicht mit einem Bezugszeichen versehen.

Das Bordnetz 2 umfasst eine Fahrzeugbatterie 6 mit einem Pluspol 8 und einem Minuspol 10, der mit einem Bezugspotential 11, wie Masse, verbunden ist. Die Fahrzeugbatterie 6 gibt über den Pluspol 8 einen elektrischen Betriebsstrom 12 ab, der diverse elektrische Verbraucher 14 in dem Bordnetz 2 mit elektrischer Energie versorgt und so betreibt. Der Betriebsstrom 12 wird dann zum Minuspol 10 zurückgeführt. Aus praktischen Gründen erfolgt dies in der Regel über das Chassis 16 des Fahrzeuges.

Der Stromsensor 4 soll den Betriebsstrom 12 erfassen, und einer verarbeitenden Recheneinrichtung, wie einem in Fig. 1 angedeuteten Batteriemanagementsystem 18 zur Verfügung stellen. Das Batteriemanagementsystem 18 ist grundsätzlich eine Schaltung, die die Fahrzeugbatterie 6 überwacht und/oder ihren Ladestand regelt. So werden diverse Schutzfunktionen realisiert, von denen eine aus der DE 20 2010 015 132 U1 bekannt ist und die Fahrzeugbatterie 6 beispielsweise vor einer Tiefenentladung schützt.

Zur Erfassung des Betriebsstromes 12 ist in dem Bordnetz 2 ein auch Shunt genannter Messwiderstand 20 angeordnet. Der Betriebsstrom 16 durchfließt diesen Messwiderstand 20 und sorgt so für einen Betriebsspannungsabfall 22 am Messwiderstand 20. Grundsätzlich erfasst der Stromsensor 2 den Betriebsspannungsabfall 22 und bestimmt basierend auf den elektrischen Eigenschaften des Messwiderstandes 20 in an sich bekannter Weise den Betriebsstrom 12. Hierzu ist der Messwiderstand 20 zweckmäßigerweise direkt am Bezugspotential 11 am Minuspol 10 verschalten, da so nur ein weitere Potentialabgriff 24 notwendig ist, um den Betriebsspannungsabfall 22 zu erfassen.

Zur Bestimmung des Betriebsstromes 12 basierend auf dem Betriebsspannungsabfall 22 greift der Stromsensor 2 den Betriebsspannungsabfall 22 am Potentialabgriff 24. Dieser Betriebsspannungsabfall 22 ist in der Regel so klein, dass er für eine direkte Signalverarbeitung zur Bestimmung des Betriebsstromes 12 unbrauchbar ist. Daher wird der Betriebsspannungsabfall 22 vor der Bestimmung des Betriebsstromes 12 zunächst verstärkt.

Zur Verstärkung des Betriebsspannungsabfalls 12 umfasst der Stromsensor 2 einen Verstärker 25, der in der vorliegenden Ausführung zweistufig ausgeführt ist. Grundsätzlich würde zu Bestimmung des Betriebsstromes 12 ein einstufiger Verstärker ausreichen. Der Verstärker 25 umfasst einen Tiefpass 26, der den Betriebsspannungsabfall 22 am Potentialabgriff 24 abgreift und ungewünschte Signalkomponenten, wie beispielsweise Schalttransiente aus diesem filtert. Der tiefpassgefilterte abgegriffene Betriebsspannungsabfall 22 wird nun mit einer Chopperschaltung 28 in ein Wechselsignal gewandelt. Die Chopperschaltung ist eine sogenannte Zerhackerschaltung, die basierend auf einem durch eine Zerhackersteuerung 29 vorgegebenen Zerhackersignal 30 den Betriebsspannungsabfall 22 in Signalperioden auftrennt und einzelne dieser aufgetrennten Signalperioden in ihrer Polarität vertauscht. Auf diese Weise wird aus dem Betriebsspannungsabfall 22 eine Wechselspannung 31 erzeugt. Chopperschaltungen sind beispielsweise aus der DE 10 2012 105 162 A1 bekannt und sollen nachstehend nicht weiter ausgeführt werden. Aufgabe der Chopperschaltung 28 ist es einen Offset sich anschließenden ersten ersten Verstärkerstufe 32 und über einen weiteren Tiefpass 26 führenden zweiten Verstärkerstufe 32 zu eliminieren. Auf einen Zwischenabgriff 33 zwischen den beiden Verstärkerstufen 32 wird an späterer Stelle eingegangen.

Die verstärkte Wechselspannung 31' am Ausgang der zweiten Verstärkerstufe 32 wird nun abschließend in einer Signalaufbereitungsschaltung 33 digitalisiert und in einen digitalen Betriebsgleichspannungswert 22' umgewandelt. Hierzu weist die Signalaufbereitungsschaltung 33 einen A/D-Wandler 34 genannten Analog-Digital-Wandler auf, der die verstärkte Wechselspannung 31' in ein nicht gezeigtes Digitalsignal umwandelt. Anschließend kann optional die Auflösung der digitalisierten verstärkten Wechselspannung 31' in einem Vorfilter 35 erhöht werden, wenn die zuvor vom A/D-Wandler 34 bereitgestellte Auflösung unzureichend ist. In jedem Fall wird die digitalisierte verstärkte Wechselspannung 31' nun in einem De-Chopperglied 36 zurück in eine nicht weiter gezeigte offsetbehaftete Wechselspannung gewandelt. Hierzu wird die digitalisierte verstärkte Wechselspannung 31' im De-Chopperglied 36 in den Perioden aus der Zerhackersteuerung 29 basierend auf einem Umkehr-Zerhackersignal 30' mit -1 und +1 multipliziert. Dadurch werden die negativen Perioden der digitalisierten verstärkten Wechselspannung 31' positiv oder salopp gesagt "nach oben geklappt". Weil die beiden Verstärkerstufen 32 die Wechselspannung 31 technisch bedingt mit einem Offset verstärken, weisen die ursprünglich positiven Perioden und die "nach oben geklappten" Perioden eine unterschiedliche Amplitude auf, weshalb es sich um eine offsetbehaftete Wechselspannung handelt. Diese offsetbehaftete Wechselspannung wird nun in einem Abschlussfilter 37 per Mittelwertbildung geglättet, wodurch der durch die beiden Verstärkerstufen 32 eingebrachte Offset ausgelöscht wird. Aus der Signalaufbereitungsschaltung 33 wird so der Betriebsspannungsabfall 22 in digitalisierter Form, i.e. als digitaler Betriebsspannungsabfall 22' ausgegeben.

Aus dem digitalen Betriebsspannungsabfall 22' kann nun in einer Umrechnungseinrichtung 38, beispielsweise mit einer die physikalischen Eigenschaften des Messwiderstandes 20 beschreibenden Kennlinie 21 aus einem Speicher 23 der zu messende Betriebsstrom 12 bestimmt und ausgegeben werden. Die Umwandlung in der Umrechnungseinrichtung 38 kann hierbei ausgehend von bekannten physikalischen Gesetzen, wie dem ohmschen Gesetz in Abhängigkeit der oben genannten physikalischen Eigenschaften 21 des Messwiderstandes 20 erfolgen. Dann wird einem Wert für die Betriebsspannung 22 ein eindeutiger Wert für den Betriebsstrom 12 zugeordnet. Das ist jedoch nur dann der Fall, wenn die zuvor genannten elektrischen Eigenschaften des Messwiderstandes 20 und damit seine Kennlinie 21 lang- und kurzzeitstabil sind. In der Regel ändern diese sich jedoch beispielsweise alters-, zustands- und/oder umgebungsbedingt. So hat bekanntermaßen die Umgebungstemperatur Einfluss auf den elektrischen Widerstand. Entsprechend stabil muss das Material für den Messwiderstand 20 für alle zuvor genannten Einflüsse gewählt werden, was in der Regel nur mit sehr kostenintensiven Materialien möglich ist.

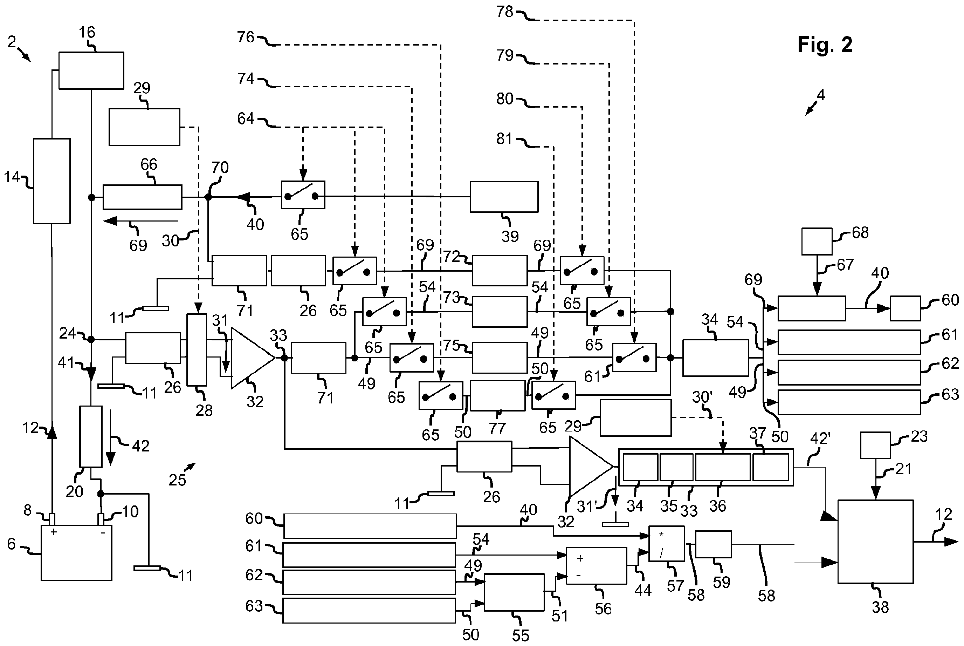

Hier soll das vorliegende Ausführungsbeispiel angreifen, was anhand von Fig. 2 beschrieben wird, in der die fein gestrichelt dargestellten Elemente aus Fig. 1 nun als normale Elemente dargestellt und mit einem Bezugszeichen versehen sind.

Idee hinter der vorliegenden Ausführung ist es, während des Betriebes des Bordnetzes 2 und damit des Stromsensors 4 aus einer Referenzstromquelle 39, auch Kalibrierstromquelle genannt, einen bekannten Referenzstrom 40, auch Kalibrierstrom genannt, in den Messwiderstand 20 einzuprägen und aus dem bekannten Referenzstrom 40 und dem am Ausgang der Signalaufbereitungsschaltung 33 abgreifbaren Spannungsabfall die tatsächlichen physikalischen Eigenschaften des Messwiderstandes 20 zu bestimmen und so dass Messergebnis des Stromsensors 4 zu korrigieren.

Diesem Gedanken steht jedoch grundsätzlich entgegen, dass während des Betriebes des Bordnetzes 2 auch der Betriebsstrom 12 fließt und so mit dem Referenzstrom 40 überlagert ist. Damit steht einem am Ausgang der Signalaufbereitungsschaltung 33 abgreifbarem Gesamtspannungsabfall 42 am Messwiderstand 20 kein bekannter Referenzstrom 40 sondern ein Gesamtstrom 41 aus dem Betriebsstrom 12 und dem Referenzstrom 40 gegenüber, so dass die tatsächlichen physikalischen Eigenschaften des Messwiderstandes 20 während des Betriebes auf diese Weise nicht ermittelbar sind.

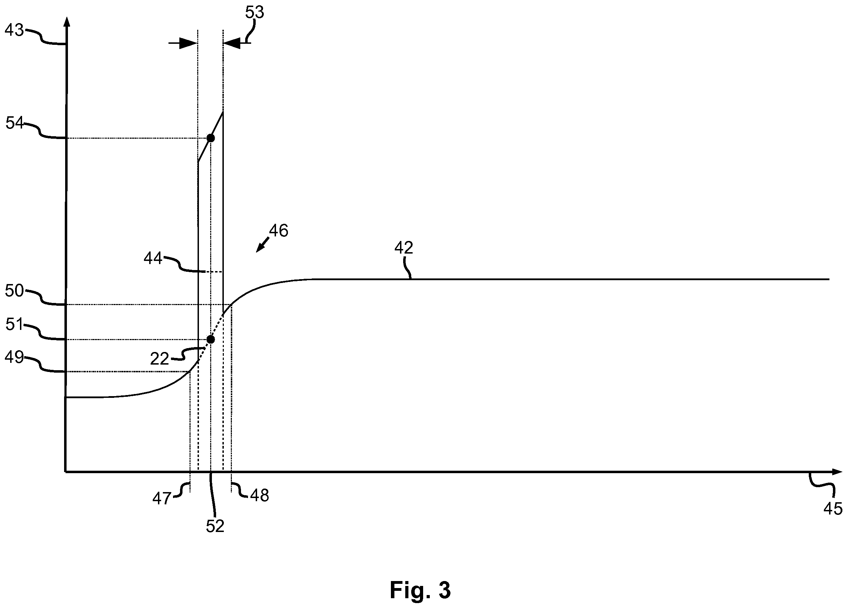

Um dennoch die tatsächlichen physikalischen Eigenschaften des Messwiderstandes 20 basierend auf dem Referenzstrom 40 ermittelbar zu machen, wird im Rahmen der vorliegenden Ausführung vorgeschlagen, den Gesamtspannungsabfall 42 von einem geschätzten Betriebsspannungsabfall 22 zu bereinigen. Der Betriebsspannungsabfall 22 während der Überlagerung des Betriebesstromes 12 und des Referenzstromes 40 kann mit hinreichender Genauigkeit geschätzt werden, was vor einer weiteren Erläuterung der Fig. 2 anhand der Fig. 3 kurz ausgeführt werden soll.

In Fig. 3 sind Spannungswerte 43 des Betriebsspannungsabfalls 22 (ohne Einwirkung des Referenzstromes 40), eines auch Kalibrierspannungsabfall genannten Referenzspannungsabfalls 44 (ohne Einwirkung des Betriebsstromes 12) und des Gesamtspannungsabfalls 42 über die Zeit 45 aufgetragen. Der vom Gesamtspannungsabfall 42 abweichende Verlauf des Betriebsspannungsabfalls 22 und des Referenzspannungsabfalls 44 sind in Fig. 3 gepunktet dargestellt. Ferner ist Fig. 3 rein qualitativ zu verstehen , wobei nicht die tatsächlichen Verhältnisse zwischen den Spannungen wiedergegeben sind.

Zum Schätzen des Betriebsspannungsabfalls 22 wird vorgeschlagen, den Referenzstrom 40 in Form eines Pulses auszuführen, so dass auch der Referenzspannungsabfall 44 die Form eines in Fig. 3 angedeuteten Pulses 46 annimmt. Weil von einem stetigen Betriebsspannungsabfall 22 ausgegangen werden kann, sollte dieser in der zeitlichen Nähe des Pulses 46 geschätzt werden. Zum Schätzen des Betriebsspannungsabfalls 22 kann jedes beliebige Schätzverfahren, bis hin zu einem Kalmann-Filter eingesetzt werden.

Technisch besonders einfach und effizient umzusetzen ist es, zu einem ersten Messzeitpunkt 47 zeitlich in unmittelbarer Nähe vor dem Puls 46 und zu einem zweiten Messzeitpunkt 48 zeitlich in unmittelbarer Nähe nach dem Puls einen Messwert 43 entsprechend einen ersten Messwert 49 und einen zweiten Messwert 50 für den Betriebsspannungsabfall 22 zu erfassen. Aus den beiden Messwerten 49, 50 kann dann ein Mittelwert 51 bestimmt werden, der mit einer ausreichenden Toleranz den des Betriebsspannungsabfalls 22 in der Mitte 52 des Pulses 46 beschreibt.

Der Mittelwert 51 beschreibt den tatsächlichen Spannungswert 43 umso genauer, je linearer der Betriebsspannungsabfalls 22 im Bereich zwischen den beiden Messzeitpunkten 47, 48 verläuft. Deshalb sollte die Pulsbreite 53 des Pulses 46 so gering wie möglich gewählt und nur durch die Grenzen der Signalverarbeitung eingeschränkt werden. Als sinnvolle Pulsbreite 53 haben sich weniger als 10ps gezeigt.

Mit dem Mittelwert 51 zum Mittenzeitpunkt 52 kann Gesamtmesswert 54 für den den Gesamtspannungsabfall 42 am Mittenzeitpunkt 52 erfasst und um den Betriebsspannungsabfall 22 bereinigt werden, so dass der durch den Referenzstrom 40 hervorgerufene Referenzspannungsabfalls 44 zum Mittenzeitpunkt 52 bekannt ist und zum Kalibrieren des Stromsensors 4 verwendet werden kann. Mit anderen Worten liegen in der vorliegenden Ausführung zum Mittenzeitpunkt 52 alle notwendigen Informationen vor, um den Stromsensor 4 zu kalibrieren.

Die technische Ausführung der Kalibrierung soll nun anhand von Fig. 2 weiter erläutert werden.

In dem Stromsensor 4 erfolgt die Mittelwertbildung zwischen den Messweren 49, 50 in einem Mittelwertbildner 55 und die Differenzbildung zwischen dem Gesamtmesswert 54 und dem Mittelwert 51 zur Bestimmung des Referenzspannungsabfalls 44 in einer Subtraktionsstufe 56. Abschließend wird in einer Dividierstufe 57 der Referenzstrom 40 durch Dividieren dem Referenzspannungsabfall 44 gegenübergestellt, woraus ein Korrekturfaktor 58 als Grundlage zur Korrektur resultiert, des unkorrigierten Betriebsstromes resultiert, der in Fig. 2 mit dem Bezugszeichen 12' versehen ist. Der Korrekturfaktor 58 kann abschließend optional noch mit einem Filterglied in Form eines Demodulators 59 gefiltert werden, um es zu glätten. Dem Demodulator 59 liegt die Überlegung zugrunde, dass über einen vergleichsweise langen Zeitraum betrachtet der Betriebsstrom 12 periodisch ist, weil er sich aus einem in die Fahrzeugbatterie 6 einfließenden Ladestrom und einem aus der Fahrzeugbatterie 6 herausfließenden Entladestrom zusammensetzt. Da die Kapazität der Fahrzeugbatterie 6 begrenzt ist, muss der Betriebsstrom 12 daher über einen langen Zeitraum betrachtet periodischen Verlauf haben und im Mittel gleich Null sein. Der Demodulator 59 betrachtet daher einen eventuellen im Korrekturfaktor 58 verbleibenden Anteil an Betriebsstrom 12 als Trägersignal und filtert es analog zu einer Demodulation (beispielsweise Amplitudendemodulation) aus diesem durch Mittelwertbildung heraus.

Der gefilterte Korrekturfaktor 58 wird nun der Umrechnungseinrichtung 38 zugeführt, die beispielsweise die Kennlinie 20 zur Bestimmung des Betriebsstromes 20 basierend auf dem Korrekturfaktor 58 korrigieren kann.

Die zur Bestimmung des Korrekturfaktors 58 notwendigen Messwerte 40, 50, 54, 59 werden in entsprechenden Speichern 60, 61, 62, 63 abgelegt. Diese Speicher 60, 61, 62, 63 sind in Fig. 1 und 2 lediglich der Übersichtlichkeit halber doppelt dargestellt, damit sich die Signalpfade nicht überkreuzen. In der Tat ist jeder Speicher nur einmal vorhanden.

Zur Befüllung der Speicher 60, 61, 62, 63 und damit zum Auslösen der Kalibrierung sind im vorliegenden Ausführungsbeispiel diverse Steuersignale vorhanden. Mit einem Referenzstromsteuersignal 64 wird ein Schalter 65 geschlossen, der den Referenzstrom 40 über einen Referenzwiderstand 66 zum Messwiderstand 20 leitet. Grundsätzlich ist der Referenzwiderstand 66 nicht notwendig, weil sich das Verfahren mit der Referenzstromquelle 39 allein durchführen lassen würde. Jedoch sind die Anforderungen an die Referenzstromquelle 39 hinsichtlich Stabilität und so weiter dann sehr hoch. Unter Verwendung des Referenzwiderstandes 66 können diese Anforderungen dann gesenkt werden, weil sich der Referenzstrom 40 basierend auf den elektrischen Eigenschaften 67 des Referenzwiderstandes 66, die in einem entsprechenden Speicher 68 hinterlegt sein können und einem entsprechenden Spannungsabfall 69 am Referenzwiderstand 66 bestimmt werden kann. Der Spannungsabfall 69 am Referenzwiderstand 66 ist dabei nicht der Referenzspannungsabfall 44, der am Messwiderstand 20 abfällt und im Gesamtspannungsabfall 42 enthalten ist. Um den Spannungsabfall 69 am Referenzwiderstand 66 möglichst einfach zu bestimmen, sollte der Referenzwiderstand 66 um ein Vielfaches größer gewählt werden, als der Messwiderstand 20. Ferner sollte der Referenzstrom 40 um ein Vielfaches höher gewählt werden, als der Betriebsstrom 12. Im Normalbetrieb, wenn der Betriebsstrom 12 beispielsweise nur Anzeigeelemente als elektrische Verbraucher 14 mit elektrischer Energie versorgt, liegt dieser im Bereich von einigen mA. Dann kann der Referenzstrom 40 im Bereich ein einem Ampere gewählt werden. Auf diese Weise kann der Spannungsabfall 69 am Referenzwiderstand 66 über einen einzigen Abgriffpunkt 70 gegenüber dem Bezugspotential 11 abgegriffen werden, wobei der Gesamtspannungsabfall 42 am Messwiderstand 20 werden kann.

Der Spannungsabfall 69 am Referenzwiderstand 66 wird mit dem Referenzstromsteuersignal 64 über einen weiteren Schalter 65, einen Hochpass 71 und einen Tiefpass 26 in einem ersten Zwischenspeicher 72 hinterlegt und kann über einen weiteren Schalter 65 aus diesem wieder abgegriffen werden. Ferner wird mit dem Referenzstromsteuersignal 64 auch der Gesamtmesswert 54 für den Gesamtspannungsabfall 42 über einen Hochpass 71 am Zwischenabgriff 33 abgegriffen und in einem zweiten Zwischenspeicher 73 hinterlegt. Der Gesamtspannungsabfall 42 ist aus Sicht des hohen Referenzstromes 40 sehr hoch. Hier kommt der Abgriff am Zwischenabgriff 33 zum Tragen. Eigentlich müssen die beiden Verstärkerstufen 32 eine vergleichsweise kleine Betriebsspannung 22 verstärken. Der demgegenüber hohe Gesamtspannungsabfall 42 würde zumindest die zweite Verstärkerstufe 32 in die Sättigung treiben und somit die Messung verfälschen. Daher sollte der Gesamtspannungsabfall 42 am Zwischenabgriff 33 abgegriffen werden.

Der Zwischenabgriff 33 hat jedoch den Nachteil, dass die entsprechenden, dort abgegriffenen Signale nicht das De-Chopperglied 36 durchlaufen. Um diesen Nachteil zu überwinden sollte sichergestellt sein, dass alle am Zwischenabgriff 33 abgegriffenen Messwerte 49, 50, 54 in einer Pulsperiode des Zerhackersignals 30 abgegriffen werden. Dann löscht sich der Offset der ersten Verstärkerstufe 32 bei der Bestimmung des Korrekturfaktors 58 automatisch heraus. Werden der erste Messwert 49 mit $U_0$, die Mitte 54 des Pulses 46 mit $U_1$, der zweite Messwert 50 mit $U_2$, der

Referenzstrom 40 mit $I_{ref}$, der Korrekturfaktor 58 mit K und der Offset der ersten Verstärkerstufe 32 mit x bezeichnet, dann kann die Bestimmung des Korrekturfaktors 58 gemäß Fig. 2 mit folgender Formel dargestellt werden:

$$K = I_{ref} / [ (U_1 + x) - 1/2 \{ (U_0 + x) + (U_2 + x) \} ]$$

Aus dieser Formel kürzt sich der Offset der ersten Verstärkerstufe 32 heraus.

Über ein erstes Messwertsteuersignal 74 kann analog zum Gesamtmesswert 54 für den Gesamtspannungsabfall 42 der erste Messwert 49 erfasst und in einem dritten Zwischenspeicher 75 hinterlegt werden, während über ein zweites Messwertsteuersignal 76 der zweite Messwert 50 erfasst und in einem vierten Zwischenspeicher 77 hinterlegt werden kann.

Der erste Zwischenspeicher 72 kann dann über ein erstes Auslesesignal 78 über einen Schalter 65 ausgelesen werden, während der zweite Zwischenspeicher 73 über ein zweites Auslesesignal 79 über einen Schalter 65 ausgelesen, der dritte Zwischenspeicher 75 über ein drittes Auslesesignal 80 über einen Schalter 65 ausgelesen und der vierte Zwischenspeicher 77 über ein viertes Auslesesignal 81 über einen Schalter 65 ausgelesen werden kann.

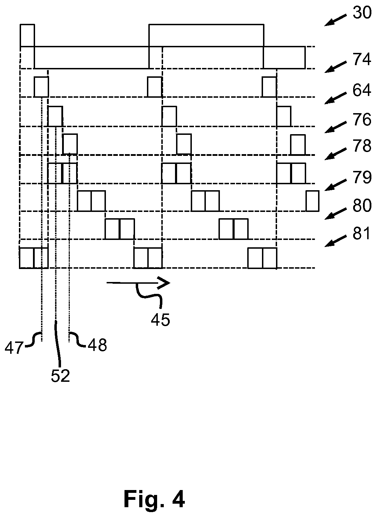

Die Steuersignale 30, 64, 74, 76, 78, 79, 80, 81 in Fig. 1 und 2 sind in Fig. 4 über die Zeit 45 aufgetragen.

Wie in Fig. 4 zu sehen ist, wird zum ersten Messzeitpunkt 47 zunächst der erste Messwert 49 mit dem ersten Messwertsignal 74 aus dem Gesamtspannungsabfall 42 mit dem entsprechenden Schalter 65 abgetastet und in dem entsprechenden Zwischenspeicher 75 hinterlegt. Sobald der erste Messwert 49 im entsprechenden Zwischenspeicher 75 vorliegt wird er über das erste Auslesesignal 78 ausgelesen und über einen A/D-Wandler 34 in seinem Speicher 62 hinterlegt.

Bereits während des Auslesens des Zwischenspeichers 75 des ersten Messwertes 49 werden in der Mitte 52 des Pulses 46 bereits der Gesamtmesswert 54 für den den Gesamtspannungsabfall 42 sowie der Spannungsabfall 69 am Referenzwiderstand 66 über die entsprechenden Schalter 65 abgetastet und in den entsprechenden Zwischenspeichern 72, 73 hinterlegt. Anschließend werden nacheinander der Zwischenspeicher 73 mit dem zweiten Auslesesignal 79 und der Zwischenspeicher 72 mit dem dritten Auslesesignal 80 ausgelesen. Der abgetastete Gesamtmesswert 54 für den den Gesamtspannungsabfall 42 wird im entsprechenden Speicher 61 hinterlegt, während der Spannungsabfall 69 am Referenzwiderstand 66 zunächst in den Referenzstrom 40 basierend auf den physikalischen Eigenschaften 67 des Referenzwiderstandes 66 umgerechnet wird, bevor dann der so bestimmte Referenzstrom 40 im entsprechenden Speicher 60 hinterlegt wird.

Im Anschluss an das Abtasten des Gesamtmesswerts 54 für den den Gesamtspannungsabfall 42 sowie des Spannungsabfalls 69 am Referenzwiderstand 66 wird abschließend am zweiten Messzeitpunkt 48 der zweite Messwert 50 mit dem zweiten Messwertsignal 76 über den Schalter 65 abgetastet und im entsprechenden Zwischenspeicher 77 hinterlegt. Das Auslesen des Zwischenspeichers 77 erfolgt analog zum Auslesen des Zwischenspeichers 73, jedoch mit dem vierten Auslesesignal 81, wobei der zweite Messwert 50 im entsprechenden Speicher 63 hinterlegt wird.

Auf diese Weise sind nun alle Messwerte 40, 49, 50, 54 in den Speichern 60 bis 63 vorhanden, so dass der Korrekturfaktor 58 gemäß Fig. 2 bestimmt werden kann.

Das Verfahren und die Ausführung des Stromsensors 4 gemäß Fig. 2 hat den Vorteil, dass bei der Digitalisierung der Messwerte 40, 49, 50, 54 nur ein einziger A/D-Wandler 34 notwendig ist, weil die Digitalisierung der Messwerte 40, 49, 50, 54 durch die zeitliche Anordnung der Steuersignale gemäß Fig. 4 entzerrt werden kann. Auf diese Weise kürzen sich auch die Digitalisierungsfehler, die durch den an der Digitalisierung beteiligten A/D-Wandler 34 zumindest in die Messwerte 49, 50, 54 eingehen, analog zum oben genannten Offset der ersten Verstärkerstufe 32 aus dem Korrekturfaktor 58 heraus.

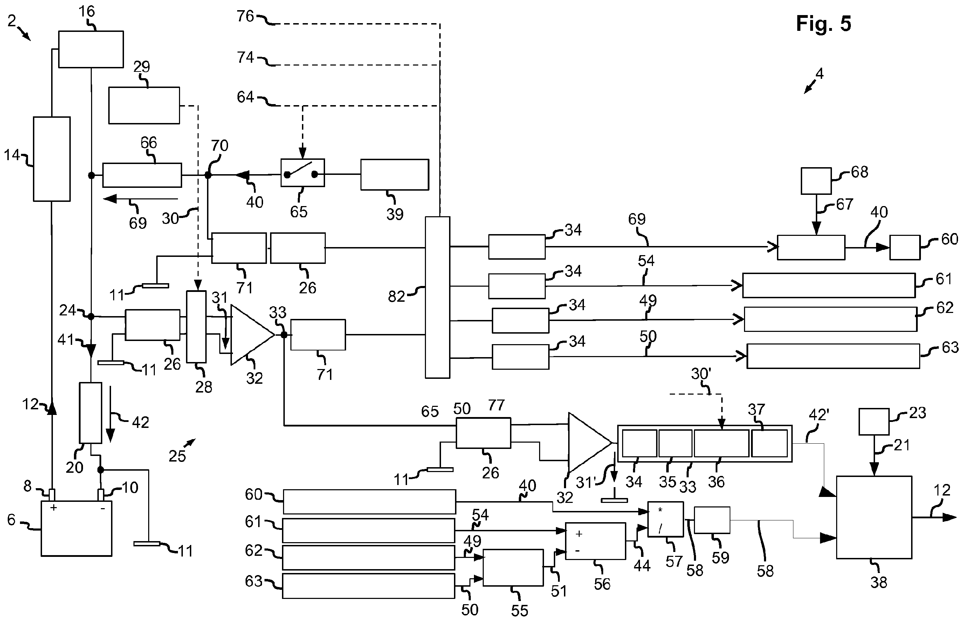

Der vergleichsweise hohe Aufwand an Steuersignalen kann jedoch mit einem alternativen Aufbau des Stromsensors 4 gemäß Fig. 5 reduziert werden.

Hier wird statt der Auslesesignale 78 bis 81 ein Multiplexer 82 verwendet. Über diesen werden die entsprechenden Messwerte 69, 54, 49, 50 unmittelbar an parallel geschaltete A/D-Wandler 34 angeschlossen. Die A/D-Wandler 34 müssen hierzu jedoch entsprechend schnell arbeitend ausgeführt sein.

Der Multiplexer 82 selbst ist nicht notwendig. Es können auch Schalter 65, wie in Fig. 1 und 2 gezeigt, verwendet werden. Mit dem Multiplexer 82 können die einzelnen A/D-Wandler 34 bei der Wandlung der Messwerte 69, 54, 49, 50 jedoch rotiert oder vertauscht werden, wodurch unterschiedliche Digitalisierungsfehler der einzelnen A/D-Wandler 34 gleichmäßig auf die einzelnen Messwerte 69, 54, 49, 50 verteilt werden. Auf diese Weise löschen sich die Digitalisierungsfehler bei der Bestimmung des Korrekturfaktors 58 analog zum oben genannten Offset der ersten Verstärkerstufe 32 ebenfalls aus.

**Patentansprüche**

1. Verfahren zum Kalibrieren eines Stromsensors (4), der eingerichtet ist, in einem Bordnetz (2) eines Fahrzeuges einen durch einen Messwiderstand (20) fließenden elektrischen Betriebsstrom (12) basierend auf einer Gegenüberstellung (38) eines durch den Betriebsstrom (12) hervorgerufenen Spannungsabfall am Messwiderstand (20) und einer vom Messwiderstand (20) abhängigen Vorschrift (21) zu bestimmen, umfassend:

   - Bestimmen eines durch den Betriebsstrom (12) am Messwiderstand (20) hervorgerufenen Betriebsspannungsabfalls (22);
   - Einprägen eines bekannten elektrischen Kalibrierstromes (40) in den Messwiderstand (20),
   - Erfassen eines durch den Kalibrierstrom (40) und den Betriebsstrom (12) am Messwiderstand (20) hervorgerufenen Gesamtspannungsabfalls (42),
   - Filtern des Betriebsspannungsabfalls (22) aus dem Gesamtspannungsabfall (42), so dass ein durch den Kalibrierstrom (40) hervorgerufener Kalibrierspannungsabfall (44) verbleibt, und
   - Kalibrieren (58) der vom Messwiderstand (20) abhängigen Vorschrift (21) basierend auf einer Gegenüberstellung (57) des Kalibrierstromes (40) und des Kalibrierspannungsabfalls (42),

   a) wobei der Kalibrierstrom (40) ein Strompuls (46) mit einer Pulsbreite (53) ist, **dadurch gekennzeichnet, dass**
   b) zum Erfassen des Betriebsspannungsabfalls (22) wenigstens zwei Betriebsspannungsmesswerten (49, 50) erfasst werden, die außerhalb des Strompulses (46) liegen und der Strompuls (46) zwischen den Betriebsspannungsmesswerten (49, 50) liegt
   c) ein Mittelwert (51) zwischen diesen wenigstens zwei Betriebsspannungsmesswerten (49, 50) gebildet wird.

2. Verfahren nach Anspruch 1, wobei der Gesamtspannungsabfall (42,54) und die Betriebsspannungsmesswerte (49, 50) zwischengespeichert (73, 75, 77) und zeitlich versetzt über einen gemeinsamen Analog-Digitalwandler (34) in je einen Digitalwert umgewandelt werden.

3. Verfahren nach Anspruch 2, wobei ein Zwischenspeicher (73) für den Gesamtspannungsabfall (54) und je ein Zwischenspeicher (75, 77) für die Betriebsspannungsmesswerte (49, 50) vorgesehen ist und während des Auslesens eines der Zwischenspeicher bereits ein anderer Messwert in einen anderen Zwischenspeicher gespeichert wird.

4. Verfahren nach Anspruch 3, wobei die Auslesesignale (78,79,80,81) zum Auslesen der Zwischenspeicher länger sind als Messwertsignale (74, 64, 76) zum Einlesen in den Zwischenspeicher.

5. Verfahren nach Anspruch 1, wobei der Gesamtspannungsabfall (42) und die Betriebsspannungsmesswerte (49, 50) mit je einem eigenen Analog-Digitalwandler (34) in je einen Digitalwert umgewandelt und in je einem eigenen Speicher (60 bis 63) hinterlegt werden, wobei die Analog-Digitalwandler (34) in zeitlichen Abständen untereinander vertauscht (82) werden.

6. Verfahren nach einem der vorhergehenden Ansprüche, wobei der durch den Kalibrierstrom (40) und den Betriebsstrom (12) am Messwiderstand (20) hervorgerufenen Gesamtspannungsabfall mittels wenigstens einer Verstärkerstufe (32) verstärkt wird, wobei der Verstärkerstufe (32) zumindest eine Chopperschaltung (28) vorgeschaltet ist, welche das Signal des Gesamtspannungsabfalls in ein Wechselsignal wandelt, wobei insbesondere die Polarität des Signals des Gesamtspannungsabfalls periodisch vertauscht wird, wobei der Betrieb und/oder die Taktung der Chopperschaltung (28) so ausgelegt ist, dass innerhalb eines Zeitintervalls, begrenzt durch die Zeitpunkte zu denen die zwei Betriebsspannungsmesswerte (49, 50) bestimmt werden, die außerhalb des Strompulses (46) erfasst werden, kein Polaritätswechsel und/oder Periodenwechsel der Chopperschaltung (28) durchgeführt wird.

7. Verfahren nach Anspruch 6, wobei beim Bestimmen des Betriebsspannungsabfalls (22) aus dem Gesamtspannungsabfall (42), ein De-Chopperglied (36) verwendet wird und beim Bestimmen des Kalibrierspannungsabfalls kein De-Chopperglied verwendet wird, sondern nach einem ersten Verstärker ein Zwischenabgriff (33) vorgesehen ist und alle am Zwischenabgriff (33) abgegriffenen Messwerte (49, 50, 54) in einer Pulsperiode des Zerhackersignals (30) abgegriffen werden.

8.  Vorrichtung, die eingerichtet ist, ein Verfahren nach einem der vorstehenden Ansprüche durchzuführen.

9.  Stromsensor (4) zum Messen eines elektrischen Stromes (12), umfassend:

    - einen elektrischen Messwiderstand (20), über den der zu messende elektrische Strom (12) führbar ist,
    - eine Vorrichtung nach Anspruch 8 zum Bestimmen des elektrischen Stromes (12) basierend auf der am elektrischen Messwiderstand (20) abfallenden Betriebsspannung (22) und der vorbestimmten Vorschrift (21) und zum Kalibrieren der Vorschrift (21).

**Claims**

1.  Method for calibrating a current sensor (4) that is set up to determine, in an onboard power supply system (2) of a vehicle, an electric operating current (12) flowing through a measuring resistor (20) based on a comparison (38) of a voltage drop across the measuring resistor (20) brought about by the operating current (12) and a rule (21) dependent on the measuring resistor (20), comprising:

    - determination of an operating voltage drop (22) brought about across the measuring resistor (20) by the operating current (12);
    - impression of a known electric calibration current (40) into the measuring resistor (20),
    - detection of a total voltage drop (42) brought about across the measuring resistor (20) by the calibration current (40) and the operating current (12),
    - filtering of the operating voltage drop (22) from the total voltage drop (42), so that a calibration voltage drop (44) brought about by the calibration current (40) remains, and
    - calibration (58) of the rule (21) dependent on the measuring resistor (20) based on a comparison (57) of the calibration current (40) and the calibration voltage drop (42),

        a) wherein the calibration current (40) is a current pulse (46) having a pulse width (53), **characterized in that**
        b) the operating voltage drop (22) is detected by detecting at least two operating voltage measured values (49, 50) that lie outside the current pulse (46) and the current pulse (46) lies between the operating voltage measured values (49, 50),
        c) a mean value (51) is formed between these at least two operating voltage measured values (49, 50).

2.  Method according to Claim 1, wherein the total voltage drop (42, 54) and the operating voltage measured values (49, 50) are buffer-stored (73, 75, 77) and each converted into a digital value at staggered times using a common analog-to-digital converter (34).

3.  Method according to Claim 2, wherein a buffer store (73) is provided for the total voltage drop (54) and one buffer store (75, 77) is provided for each of the operating voltage measured values (49, 50), and another measured value is already stored in another buffer store during the actual reading of one of the buffer stores.

4.  Method according to Claim 3, wherein the read signals (78, 79, 80, 81) for reading the buffer stores are longer than measured value signals (74, 64, 76) for reading into the buffer store.

5.  Method according to Claim 1, wherein the total voltage drop (42) and the operating voltage measured values (49, 50) are each converted into a digital value using a separate analog-to-digital converter (34) each and are each stored in a separate memory (60 to 63), the analog-to-digital converters (34) being interchanged with one another (82) at intervals of time.

6.  Method according to one of the preceding claims, wherein the total voltage drop brought about across the measuring resistor (20) by the calibration current (40) and the operating current (12) is amplified by means of at least one amplifier stage (32),
    wherein the amplifier stage (32) has at least one chopper circuit (28) connected upstream of it that converts the signal from the total voltage drop into an AC signal, wherein particularly the polarity of the signal from the total voltage drop is periodically interchanged, wherein the operation and/or clocking of the chopper circuit (28) is designed such that within an interval of time, bounded by the times at which the two operating voltage measured values (49, 50) that are detected outside the current pulse (46) are determined, no polarity change and/or period change for the chopper circuit (28) is performed.

**7.** Method according to Claim 6, wherein determination of the operating voltage drop (22) from the total voltage drop (42) involves a dechopper element (36) being used, and determination of the calibration voltage drop involves no dechopper element being used, but rather an intermediate tap (33) is provided downstream of a first amplifier and all measured values (49, 50, 54) tapped off from the intermediate tap (33) are tapped off in a pulse period of the chopper signal (30).

**8.** Apparatus that is set up to perform a method according to one of the preceding claims.

**9.** Current sensor (4) for measuring an electric current (12), comprising:

- an electrical measuring resistor (20) via which the electric current (12) to be measured is routable,
- an apparatus according to Claim 8 for determining the electric current (12) based on the operating voltage (22) dropped across the electrical measuring resistor (20) and the predetermined rule (21) and for calibrating the rule (21).

**Revendications**

**1.** Procédé d'étalonnage d'un détecteur de courant (4), qui est conçu pour déterminer un courant de service (12) électrique qui circule à travers une résistance de mesure (20) dans un réseau de bord (2) d'un véhicule automobile en se basant sur une comparaison (38) d'une chute de tension aux bornes de la résistance de mesure (20) provoquée par le courant de service (12) et une règle (21) dépendante de la résistance de mesure (20), comprenant :

- la détermination d'une chute de tension de service (22) provoquée par le courant de service (12) aux bornes de la résistance de mesure (20) ;
- l'incrustation d'un courant d'étalonnage (40) électrique connu dans la résistance de mesure (20),
- la détection d'une chute de tension totale (42) aux bornes de la résistance de mesure (20) provoquée par le courant d'étalonnage (40) et le courant de service (12),
- l'élimination par filtrage de la chute de tension de service (22) de la chute de tension totale (42) de sorte qu'il demeure une chute de tension d'étalonnage (44) provoquée par le courant d'étalonnage (40), et
- l'étalonnage (58) de la règle (21) dépendante de la résistance de mesure (20) en se basant sur une comparaison (57) du courant d'étalonnage (40) et de la chute de tension d'étalonnage (42),

a) le courant d'étalonnage (40) étant une impulsion de courant (46) ayant une largeur d'impulsion (53),
**caractérisé en ce que**
b) la détection de la chute de tension de service (22) s'effectue en détectant au moins deux valeurs de mesure de tension de service (49, 50) qui se trouvent en-dehors de l'impulsion de courant (46) et l'impulsion de courant (46) se trouve entre les valeurs de mesure de tension de service (49, 50)
c) une valeur moyenne (51) entre ces au moins deux valeurs de mesure de tension de service (49, 50) est formée.

**2.** Procédé selon la revendication 1, la chute de tension totale (42, 54) et les valeurs de mesure de tension de service (49, 50) étant mémorisées temporairement (73, 75, 77) et respectivement converties en une valeur numérique par le biais d'un convertisseur analogique/numérique (34) commun en étant décalées dans le temps.

**3.** Procédé selon la revendication 2, une mémoire temporaire (73) étant présente pour la chute de tension totale (54) et une mémoire temporaire (75, 77) respectivement pour les valeurs de mesure de tension de service (49, 50) et pendant la lecture de l'une des mémoires temporaires, une autre valeur mesurée étant déjà mémorisée dans une autre mémoire temporaire.

**4.** Procédé selon la revendication 3, les signaux de lecture (78, 79, 80, 81) destinés à la lecture des mémoires temporaires étant plus longs que les signaux de valeur mesurée (74, 64, 76) destinés à être inscrits dans les mémoires temporaires.

**5.** Procédé selon la revendication 1, la chute de tension totale (42) et les valeurs de mesure de tension de service (49, 50) étant respectivement converties en une valeur numérique par le biais d'un convertisseur analogique/numérique (34) propre respectif et étant respectivement enregistrées dans une mémoire propre (60 à 63), les convertisseurs analogique/numérique (34) étant intervertis entre eux (82) à des intervalles de temps donnés.

**6.** Procédé selon l'une des revendications précédentes, la chute de tension totale provoquée par le courant d'étalonnage (40) et le courant de service (12) aux bornes de la résistance de mesure (20) étant amplifiée au moyen d'au moins un étage amplificateur (32),
au moins un circuit hacheur (28) étant branché en amont de l'étage amplificateur (32), lequel convertit le signal de la chute de tension totale en un signal alternatif, au moins la polarité du signal de la chute de tension totale étant périodiquement inversée,
le fonctionnement et/ou le cadencement du circuit hacheur (28) étant conçu de telle sorte qu'aucun changement de polarité et/ou changement de période du circuit hacheur (28) n'est effectué à l'intérieur d'un intervalle de temps délimité par les instants auxquels sont déterminées les deux valeurs de mesure de tension de service (49, 50) qui sont détectées en-dehors de l'impulsion de courant (46) .

**7.** Procédé selon la revendication 6, un élément de suppression de hachage (36) étant utilisé lors de la détermination de la chute de tension de service (22) à partir de la chute de tension totale (42) et aucun élément de suppression de hachage n'étant utilisé lors de la détermination de la chute de tension d'étalonnage, mais une prise intermédiaire (33) se trouvant après un premier amplificateur et toutes les valeurs mesurées (49, 50, 54) prélevées au niveau de la prise intermédiaire (33) étant prélevées dans une période d'impulsion du signal de hacheur (30).

**8.** Dispositif, qui est conçu pour mettre en œuvre un procédé selon l'une des revendications précédentes.

**9.** Détecteur de courant (4) destiné à mesurer un courant électrique (12), comprenant :

- une résistance de mesure (20) électrique par le biais de laquelle peut passer le courant électrique (12) à mesurer,
- un dispositif selon la revendication 8 destiné à déterminer le courant électrique (12) en se basant sur la tension de service (22) qui chute aux bornes de la résistance de mesure (20) et la règle (21) prédéterminée et destiné à étalonner la règle (21).

**Fig. 1**

Fig. 2

**Fig. 3**

Fig. 4

Fig. 5

**Fig. 6**

EP 3 195 000 B1

**EP 3 195 000 B1**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 102009044992 A1
- DE 102004062655 A1
- DE 102010028066 A1
- DE 202010015132 U1
- DE 102012105162 A1